Europäisches Patentamt

European Patent Office

Office européen des brevets

(1) Veröffentlichungsnummer: **0 291 643**
**A2**

## EUROPÄISCHE PATENTANMELDUNG

(21) Anmeldenummer: **88102889.8**

(22) Anmeldetag: **26.02.88**

(51) Int. Cl.4: **H01L 27/14**

(30) Priorität: **11.05.87 DE 3715675**

(43) Veröffentlichungstag der Anmeldung:
**23.11.88 Patentblatt 88/47**

(84) Benannte Vertragsstaaten:
**CH DE FR GB LI NL**

(71) Anmelder: **Messerschmitt-Bölkow-Blohm**
**Gesellschaft mit beschränkter Haftung**
**Robert-Koch-Strasse**
**D-8012 Ottobrunn(DE)**

(72) Erfinder: **Kemmer, Josef, Dr.**
**Hauptstrasse 41D**
**D-8048 Haimhausen(DE)**
Erfinder: **Lutz, Gerhard, Dr.**
**Therese-Giehse-Allee 23**
**D-8000 München 83(DE)**

(54) **Halbleiterelement.**

(57) Bei einem Halbleiterelement mit einem Halbleiterkörper aus einem Material mit einer ersten Leitfähigkeit, der auf mindestens einer Hauptoberfläche eine Elektrodenstruktur aufweist, die wenigstens die Speicherung von Ladungsträgern mindestens einer Leitfähigkeit in Zellen erlaubt, werden gemäß der Erfindung in mindestens einer Ebene parallel zu der Hauptoberfläche vom Halbleiterkörper vollständig oder teilweise umschlossene Steuerelektroden vorgesehen, die ebenfalls die Speicherung von Ladungsträgern in Zellen ermöglichen.

Dadurch wird es möglich, wenigstens zwei Ladungsbilder zu speichern.

FIG. 1

EP 0 291 643 A2

## Halbleiterelement

Die Erfindung betrifft ein Halbleiterelement gemäß dem Oberbegriff des Patentanspruchs 1.

Halbleiterelemente nach diesem Oberbegriff sind bekannt. Beispiele dafür sind CCDs sowie unter anderem das in Nucl. Instr. & Meth. A 253 (1987) 365 beschriebene Matrix Pixel Array.

Diesen Elementen gemeinsam ist die Eigenschaft, daß in der Regel nur ein Ladungsbild gespeichert und ausgelesen werden kann. Die Aufnahme eines oder mehrerer neuer Ladungsbilder würde das ursprüngliche Ladungsbild verändern und kann daher erst nach vollständigem Auslesen oder Löschen des vorhergehenden Ladungsbildes erfolgen.

Der Erfindung liegt die Aufgabe zugrunde, ein Halbleiterelement gemäß dem Oberbegriff des Anspruchs 1 derart weiterzubilden, daß wenigstens zwei LAdungsbilder gespeichert werden können.

Eione erfindungsgemäße Lösung dieser Aufgabe ist mit ihren Weiterbildungen in den Patentansprüchen gekennzeichnet.

Die Möglichkeit der Speicherung von mindestens zwei unterschiedlichen Ladungsbildern wird erfindungsgemäß dadurch erreicht, daß im Inneren des Halbleiterkörpers in mindestens einer Ebene parallel zur Hauptoberfläche vorhandene Steuerelektroden eine Verschiebung des Ladungsbildes senkrecht zur Hauptoberfläche ermöglichen.

Die Erfindung wird nachstehend anhand eines Ausführungsbeispiels unter Bezugnahme auf die Zeichnung näher beschrieben, in der zeigen:

Fig. 1 ein erstes Ausfürungsbeispiel der Erfindung,

Fig. 2 eine Modifikation des Ausführungsbeispiels gemäß Fig. I, das die Speicherung mehrerer Ladungsbilder erlaubt,

Fig. 3 bis 5 den Potentialverlauf von erfindungsgemäßen Elementen, und

Fig. 6 eine weitere Modifikation mit geänderter Elektrodenstruktur.

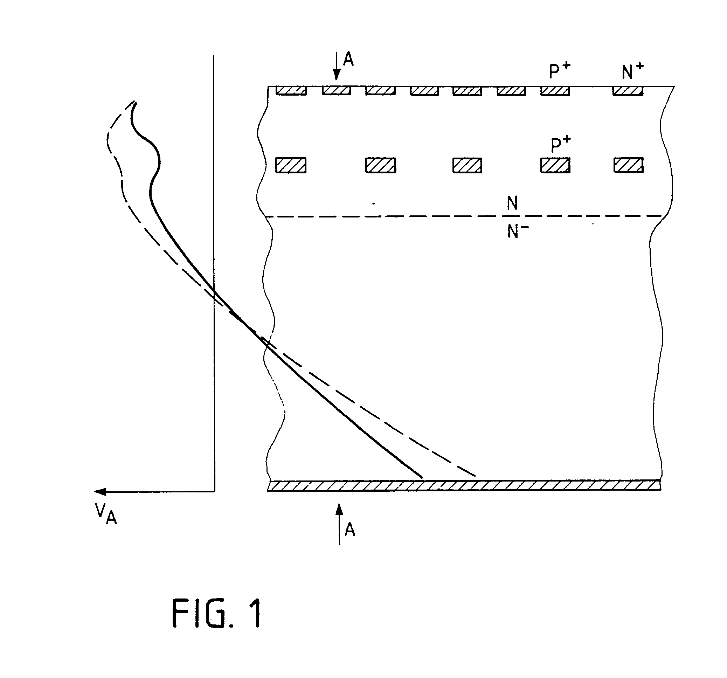

Eine Struktur, die die Aufnahme und/oder Speicherung eines Ladungsbildes während dem Auslesen des vorhergehenden Ladungsbildes erlaubt, ist in Fig. 1 gezeigt. Diese Struktur kann als Strahlungsdetektor verwendet werden.

In dem gewählten Beispiel hat die obere Hauptoberfläche die Struktur eines P-N CCDs wie sie z. B. in Nucl. Instr. & Meth. A 253 (1987) 386 beschrieben ist. In einer Ebene parallel zur Hauptoberfläche im Inneren des N-dotierten Halbleiterkörpers befindet sich ein hochdotiertes $p^+$ Gitter, an das von außen eine Spannung angelegt werden kann. Die untere Hauptoberfläche ist mit einer großflächigen $p^+$ Elektrode versehen.

An $p^+$ Elektroden der ersten und zweiten Haupttoberfläche sowie an das Gitter können nun solcherart Potentiale angelegt werden, daß bei volldepletiertem Grundkörper entweder

a) Potentialmaxima nur zwischen Gitterebene und oberer Hauptoberfläche entstehen. In diesem Falle könnte die Anordnung wie ein normaler Majoritätsladungstrager CCD betrieben werden und die Gitterebene hätte keine wesentliche Funktion oder

b) sich zusätzlich zu den unter a) beschriebenem Potentialmaxima weitere periodisch angeordnete Maxima etwas unterhalb der Gitterebene jeweils in der Mitte zwischen den Gitterelektroden ausbilden.

Werden im Falle b) im Volumen unterhalb der Gitterebene Ladungsträger z. B. durch ionisierende Strahlung erzeugt, so werden die Elektronen in den Potentialmaxima unter der Gitterebene gesammelt und festgehalten. Sie können dann durch die Veränderung der Potentiale an den Elektroden in die Region zwischen Gitter und oberer Hauptoberfläche transferiert werden. Dies geschieht z. B. durch Erhöhung des Gitterpotentials und/oder Erniedrigung des Potentials an der unteren Hauptoberfläche und führt zu der unter a) beschriebenen Potentialkonfiguration.

Danach kann das Auslesen mittels der CCD-Struktur an der oberen Hauptoberfläche erfolgen, wobei gleichzeitig ein neues Ladungsbild aufgenommen und gespeichert werden kann. Im angeführten Beispiel (Fig. 1) wird eine höhere Dotierung in der oberen Region als im Rest des Grundkörpers angenommen. Dies hat den Vorteil, daß genügend ausgeprägte Potentialmaxima bei wesentlich kleineren Potentialdifferenzen zwischen den beiden Hauptebenen erreicht werden, als bei gleichmäßiger Dotierung möglich wäre.

Die Gitterelektroden können streifenförmig oder gitterförmig ausgebildet sein. Eine gitterförmige Ausbildung hat den Vorteil einer zweidimensionalen Anordnung von Potentialmaxima unter der Gitterebene. Bei streifenförmiger Ausbildung muß dies durch zusätzliche Maßnahmen wie z. B. Veränderung der Dotierungsdichte, ähnlich zu "channel stops" in CCDs oder durch periodische Verdickung der Gitterstreifen erreicht werden.

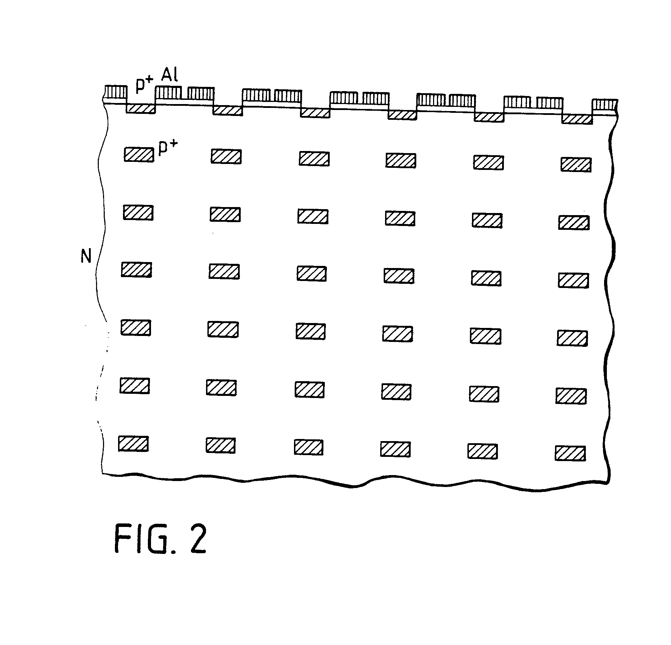

Bei dem in Fig. 2 dargestellten Ausführungsbeispiel können mehrere Ladungsbilder in Ebenen parallel zur Hauptoberfläche gespeichert werden. Hier ist die obere Hauptebene als "random ccess Pixel device" ausgebildet. Durch Einführung einer Vielzahl von Gitterebenen im Inneren des Grundkörpers ist es möglich, die vorher beschriebenen periodisch angeordneten Potentialmaxima in mehreren Ebenen übereinander zu erhalten. So läßt sich also eine dreidimensional periodische Anordnung der Potentialmaxima erreichen.

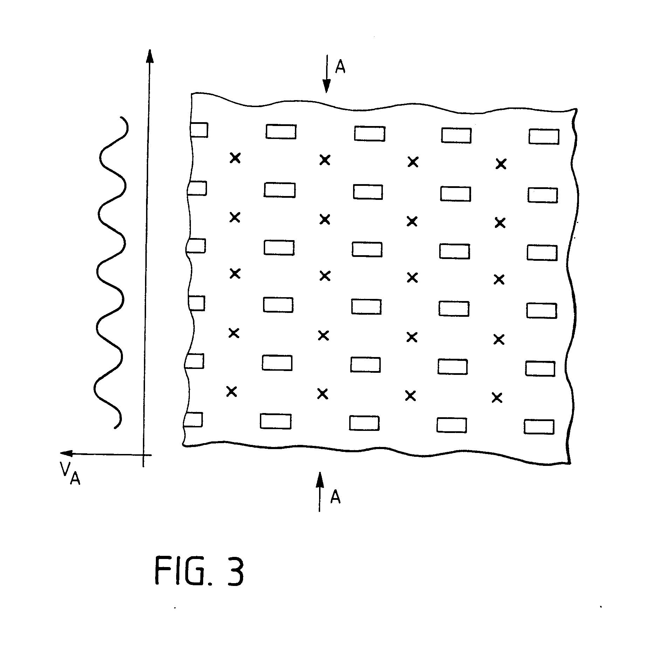

Dies ist in verschiedener Weise möglich. Sind z. B. alle Gitterelektroden auf gleichem Potential, so bilden sich wie schematisch in Fig. 3 daringestellt, jeweils in der Mittelebene zwischen zwei Gitterebenen die Potentialmaxima (x) aus. Der Potentialverlauf bei vollständig verarmten Grundkörpern in Richtung senkrecht zur Hauptebene auf der Verbindungslinie zwischen diesen Maxima, ist in der Abbildung ebenfalls dargestellt.

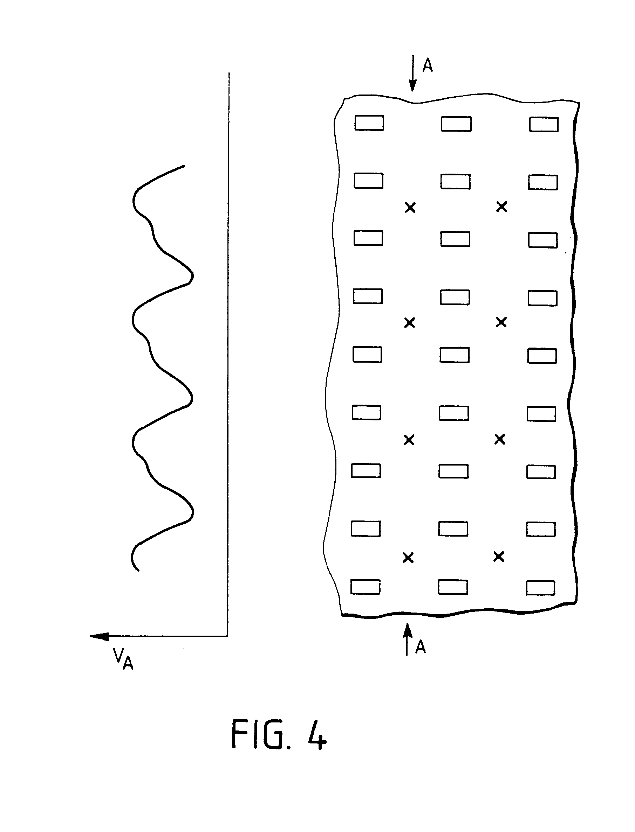

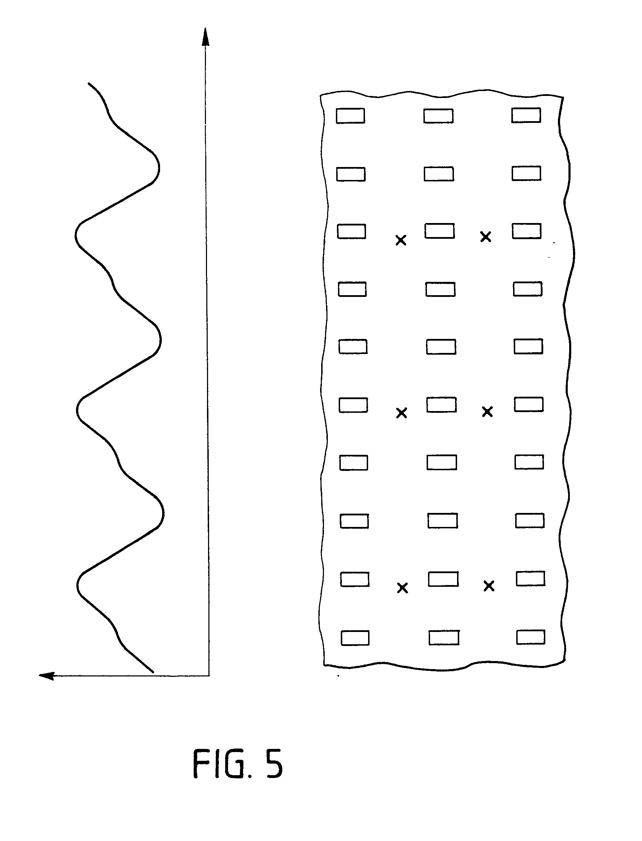

Es ist auch möglich, an die Gitterelektroden verschiedene Potentiale anzulegen, in einer Weise, daß z. B. Potentialmaxima nur zwischen jeder zweiten (Fig. 4) oder dritten (Fig. 5) Gitterelektrode entstehen. Die Potentialverteilung in Fig. 5 ist ähnlich der eines Dreiphasen-CCD, jedoch nicht wie üblicherweise parallel zur Hauptoberfläche, sondern senkrecht dazu.

Die vorhin besprochenen, in einer dreidimensionalen Gitterstruktur angeordneten Potentialmaxima können zur analogen Ladungsspeicherung verwendet werden. Für eine Verschiebung von jeweils in einer Ebene angeordneten Bildern senkrecht zur Hauptoberfläche bestehen verschiedene Möglichkeiten. Geht man z. B. von den Verhältnissen in Fig. 5, also Ladungsspeicherung in Abstand von 3 Gitterebenen aus, so kann der Ladungstransfer völlig analog zu einem Drei-Phasen-CCD, jeoch in vertikaler Richtung erfolgen.

Ausgehend von Fig. 4 mit Ladungsspeicherung im Abstand von 2 Gitterebenen kann man analog zum 2-Phasen-CCD arbeiten, wenn jeweils zwischen den Gitterebenen z. B. durch Veränderung der Dotierungskonzentration des Grundkörpers ein Potentialgradient senkrecht zur Hauptoberfläche eingebaut wird. Dies kann bei Epitaxialem Aufbau der Struktur relativ einfach erreicht werden. Wie in dem vorhergehenden Fall bewirkt die vorgeschlagene Betriebsart eine gleichzeitige Verschiebung von allen Ladungsbildern senkrecht zur Hauptoberfläche jedoch ist die Bewegungsrichtung durch den eingebauten Gradierungsgradienten festgelegt.

Auch die in Fig. 3 beschriebene Anordnung ist für die Speicherung und den Ladungstransfer senkrecht zur Hauptoberfläche geeignet. Sie zeichnet sich durch Vergrößerung der Anzahl der gleichzeitig speicherbaren Bilder aus. Der Ladungstransfer ist jedoch langsamer und umständlicher, da jeweils eine Speicherebene geleert werden muß bevor der Inhalt der benachbarten Speicherebene dahin transferiert werden kann. Verschiebung aller Ladungsbilder um ein Stockwerk kann also nur nacheinander erfolgen.

Besteht die Möglichkeit, die Elektroden der zur Hauptoberfläche parallelen Gitterebenen auf voneinander verschiedene Potentiale einzustellen, wie z. B. streifenförmiger Ausbildung der Elektroden, so kann man auch eine Verschiebung der Ladungen in einer, mehrerer oder in allen Speicherebenen parallel zur Hauptoberfläche bewirken. Dies kann in analoger Weise zur vorher beschriebenen CCD ähnlichen Bewegung in vertikaler Richtung geschehen. Ebenso wie vorher wird dann in horizontaler Richtung bei 3-Phasen-CCD Betriebsart nur jedes dritte mögliche Potentialmaximum zur Ladungsspeicherung verwendet.

Wie bereits vorher bemerkt, sind bei streifenförmiger Elektrodenstruktur Maßnahmen zur Verhinderung des Auseinanderfließens der Ladung in Streifenrichtung nötig. Außer den bereits beschriebenen Channelstops bzw. den periodischen Verdickungen der Elektroden, ist dies auch dadurch erreichbar, daß Streifen in übereinander liegenden Gitterebenen gekreuzt sind. Mit einer derartigen Anordnung ist es dann auch möglich, je nach Auswahl der angesteuerten Gitterebene, zusätzlich zur Bewegungsrichtung der Ladungsträger senkrecht zur Hauptoberfläche 2 oder mehrere Bewegungsrichtungen parallel zur Hauptoberfläche möglich zu machen.

Wie bereits erwähnt, kann das Halbleiterelement als Strahlungssensor mit Speichermöglichkeit für mehrere zeitlich aufeinander folgender Bilder verwendet werden. Möglich ist auch das Summieren oder Subtrahieren von verschiedenen Bildern oder der Vergleich mit einem im vorhinein aufgenommenen Referenzbild. Eine Möglichkeit zur Subtraktion ergibt sich bei Ausbildung der Hauptoberfläche als Random Access Pixel Device, jedoch in einer Weise, daß jeweils ein Paar von nebeneinander liegenden DEPMOS Transistoren die Eingänge eines Differenzverstärkers bilden. Der dem Pixel Device zugrunde liegende UEPMOS Transistor und entsprechende Schaltungen sind in Nuc. Instr. & Meth. A 253 (1987) 356 beschrieben. Vergleichsbild und Bild müssen dann jeweils unter dem anderen Gate des DEPMOS Transistorpaares deponiert werden. Dies läßt sich durch Ausnutzung der Verschiebungsmöglichkeiten parallel zur Hauptoberfläche erreichen. Das Vergleichsbild muß im übrigen nicht unbedingt optisch aufgenommen werden, es könnte unter anderem auch durch elektrodisches Einkoppeln von Signalen wie z. B. bei einem CCD erfolgen.

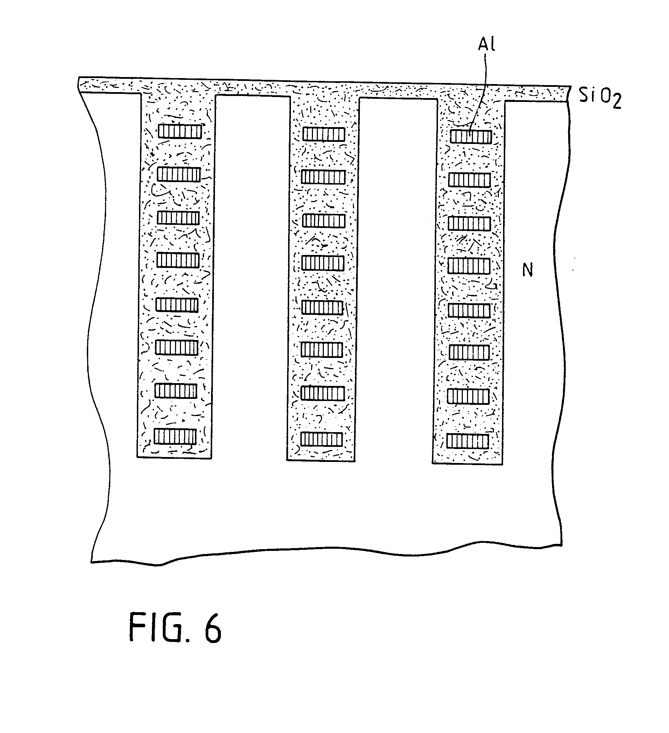

In den bisher beschriebenen Ausführungsformen wurden die Gitter durch zum Grundkörper entgegengesetzt dotierten Halbleitermaterial gebildet. Eine Schwierigkeit kann sich dabei durch den elektrischen Widerstand der Gitterelemente ergeben, wenn Betrieb mit hoher Geschwindigkeit erforderlich ist. Vorteilhaft in diesem Falle sind Elektroden mit hoher Leitfähigkeit wie z. B. Metallelektroden. Diese müssen allerdings vom Halbleiterkörper elektrisch isoliert werden. Eine mögliche Anordnung dieser Elektroden ist in Fig. 6 schematisch dargestellt. Die Gitterelektroden bestehend z. B. aus Aluminium, sind in tiefen Gräben im Halbleiter versenkt und durch elektrisch isolierendes Material (z. B $SiO_2$) vom Halbleiter getrennt.

In den bisher beschriebenen Anwendungsmöglichkeiten als Detektor wurde davon ausgegangen, daß im wesentlichen der unstrukturierte Hauptteil des Grundkörpers zum Strahlungsnachweis, der strukturierte, die Gitterelektroden beinhaltende Teile, als Speicherelement verwendet wird. Dies ist insbesondere für langreichweitige oder durchdringende Strahlung angebracht. Für kurzreichweitige Strahlung (z. B. sichtbares Licht) ist auch eine Einstrahlung von der strukturierten Seite möglich. Dies ist unter anderem eine Möglichkeit zum Einbringen eines Vergleichsbildes von der Gengenseite zum normalen Bild.

Eine weitere Möglichkeit bildet die direkte Verwendung des strukturierten Teiles des Halbleiterelements mit seinen dreidimensional angeordneten Potentialmaxima als Detektor und nicht als Speicherregion für zeitlich aufeinander folgend aufgenommene Ladungsbilder. Diese Art der Anwendung erlaubt eine Unterscheidung von Strahlung unterschiedlicher Eindringtiefe (Farbe) und kann auch zur Messung der Einfallsrichtung der Strahlung verwendet werden.

Je nachdem, ob die Anwendung des strukturierten Teiles des Halbleiterkörpers als Strahlungsdetektor oder als Speicherelement im Vordergrund steht, wird man im strukturierten Teil das Volumen der Gitterelektroden im Verhältnis zum strahlungssensitiven Teil des Grundkörpers groß oder klein halten.

## Ansprüche

1. Halbleiterelement mit einem Halbleiterkörper aus einem Material aus einer ersten Leitfähigkeit, der auf mindestens einer Hauptoberfläche eine Elektrodenstruktur aufweist, die wenigstens die Speicherung von Ladungsträger mindestens einer Leitfähigkeit in Zellen erlaubt. dadurch **gekennzeichnet,** daß in mindestens einer Ebene parallel zu der Hauptoberfläche vom Halbleiterkörper vollständig oder teilweise umschlossene Steuerelektroden vorgesehen sind, die ebenfalls die Speicherung von Ladungsträgern in Zellen ermöglichen.

2. Halbleiterelement nach Anspruch 1, dadurch **gekennzeichnet,** daß zur Ladungsspeicherung in dreidimensional angeordneten Speicherelementen und zum Ladungstransfer senkrecht zur Hauptoberfläche im Inneren des Halbleiterkörpers Steuerelektroden in mehreren Ebenen übereinander angeordnet sind.

3. Halbleiterelement nach Anspruch 1 oder 2, dadurch **gekennzeichnet,** daß die Elektrodenstruktur die Verschiebung von Ladungsträgern in den Ebenen im Inneren des Halbleiterkörpers parallel zu den Hauptoberflächen ermöglicht.

4. Halbleiterelement nach einem der Ansprüche I bis 3, dadurch **gekennzeichnet,** daß die im Inneren des Halbleiter korpers vorgesehenen Steuerelektroden Gebiete der zweiten Leitfähigkeit sind.

5. Halbleiterelement nach einem der Ansprüche 1 bis 4, dadurch **gekennzeichnet,** daß die im Inneren des Halbleiterkörpers vorgesehene Steuerelektroden ganz oder teilweise von einer isolierenden Schicht umgeben sind.

6. Halbleiterelement nach einem der Ansprüche 1 bis 5, dadurch **gekennzeichnet,** daß die im Inneren des Halbleiterkörpers vorgesehenen Steuerelektroden gitterförmig ausgebildet sind.

7. Halbleiterelement nach einem der Ansprüche 1 bis 6, dadurch **gekennzeichnet,** daß die Steuerelektroden streifenförmige Strukturen haben.

8. Halbleiterelement nach Ansprüche 7, dadurch **gekennzeichnet,** daß senkrecht zur Streifenrichtung channel stops angeordnet sind.

9. Halbleiterelement nach Anspruch 7, dadurch **gekennzeichnet,** daß die Breite und/oder die Dotierung der Streifenelektroden längs der Streifenrichtung variiert.

10. Halbleiterelement nach Anspruch 7, dadurch **gekennzeichnet,** daß die Richtung der Streifen in übereinander liegenden Ebenen nicht übereinstimmt.

11. Halbleiterelement nach einem der Ansprüche 1 bis 10, dadurch **gekennzeichnet,** daß der Körper inhomogen derart dotiert ist, daß die Ladungsverschiebung senkrecht zur Hauptoberfläche eine Vorzugsrichtung aufweist.

12. Halbleiterelement nach einem der Ansprüche 1 bis 11, dadurch **gekennzeichnet,** daß die erste Hauptoberfläche eine Elektrodenstruktur aufweist, die die Speicherung in Zellen und die Verschiebung der gespeicherten ladungsträger parallel zu den Hauptoberflächen oder direkte Messung der in den Zellen gespeicherten Ladung erlaubt.

13. Halbleiterelement nach einem der Ansprüche I bis 12, dadurch **gekennzeichnet,** daß auf der zweiten Hauptoberfläche Elektroden vorgesehen sind, die es erlauben, den Grundkörper als Strahlungsdetektor und die innere Elektrodenstruktur als Ladungsspeicher zu verwenden.

14. Halbleiterelement nach einem der Ansprüche 1 bis 13,
dadurch **gekennzeichnet,** daß das Ladungsspeicherelement als Detektor betrieben werden kann und die durch einfallende Strahlung erzeugten Ladungsträger in den entsprechenden Zellen speicherbar sind.

15. Halbleiterelement nach einem der Ansprüche I bis 14,
dadurch **gekennzeichnet,** daß über geeignete Strukturen in das Halbleiterelement injiziert werden können und es somit als dreidimensioneler Analog- oder Digitalspeicher verwendet werden kann.

FIG. 1

FIG. 2

10 160

FIG. 3

10 160

FIG. 4

FIG. 5

FIG. 6